# EUROPEAN PATENT APPLICATION

(11) **EP 4 465 345 A1**
(43) Date of publication of application: **20.11.2024**
(21) Application number: 23173969.9
(22) Date of filing: 17.05.2023
(51) Int. Cl.: H01L 23/00

(54) **SEMICONDUCTOR DEVICE PACKAGE INTERCONNECT AND MANUFACTURING METHOD THEREOF**

(71) Applicant: Nexperia B.V., 6534 AB Nijmegen (NL)
(72) Inventor: NG, Siu Lung, Hong Kong (HK); POELMA, Regnerus Hermannus, Nijmegen (NL); CHEUNG, Yuet Keung, Hong Kong (HK)
(74) Representative: Pjanovic, Ilija

(57) **Abstract**

Manufacturing of a semiconductor device package 100 including a die 110, a substrate 120, a first connection area 112 and a second connection area 122, the first connection area providing an electrical connection to the die, the second connection area providing an electrical connection to a substrate bond pad, and the first and connection area facing in the same direction, wherein a non-conductive material is applied and cured between an edge of the first connection area and an edge of the second connection area and along a side of the die, and wherein a conductive material is applied and cured between the first connection area and the second connection area and along a surface of the cured non-conductive material.

## Description

### Technical field

The present disclosure relates to a method of manufacturing a semiconductor device package and a semiconductor device package manufactured using such method. More specifically, the present disclosure relates to bonding a die to a substrate bond pad, leadframe or clip frame on a substrate.

### Background

Discrete packages in semiconductors refer to individual electronic devices that are packaged separately and are not integrated into a larger system. A discrete semiconductor device package may include components such as diodes, transistors, and voltage regulators, among others. They are typically designed to perform specific functions and can be used in a variety of electronic applications, such as power supplies, amplifiers, and switching circuits.

Discrete packages are typically relatively small in size and are typically encapsulated in a plastic or metal case to protect the semiconductor material from damage. Leads of the component may extend from the package and may be used to connect the component to a circuit board or other electronic device.

Discrete semiconductor device packages typically include a die and a substrate bond pad provided on a substrate. The substrate bond pad may be used to form a lead extending from the package, either directly or via a lead connected to the substrate bond pad.

The die may be electrically connected to the substrate bond pad through bonding. Known bonding methods include clip bonding and wire bonding. With clip bonding a metal clip may be placed and soldered to the corresponding contacts on the substrate bond pad and the die. Disadvantageously, the soldering typically involves the use of high-lead (Pb) solder, which is environmentally unfriendly. With wire bonding, thin conductive wires may be connected to the corresponding contacts on the substrate bond pad and the die. Disadvantageously, wire bonding is more susceptible to reliability issues due to the potential for wire breakage or corrosion over time.

### Summary

The present disclosure proposes a new method and interconnect for bonding a die to a substrate bond pad, leadframe or clip frame on a substrate within a semiconductor device package, without the above mentioned disadvantages of known clip bonding and wire bonding methods. The present disclosure is particularly advantageous to discrete semiconductor device packages, but may also be applied to other packages, such as integrated circuit (IC) packages. The IC may form a sensor or any other IC device.

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a method of manufacturing a semiconductor device package is presented. The semiconductor device package may include a die, a substrate, a first connection area and a second connection area. The first connection area may provide an electrical connection to the die. The second connection area may provide an electrical connection to a substrate bond pad provided on the substrate. The first connection area and the second connection area may face in the same direction. The method may include applying a non-conductive material, such as a non-conductive liquid, between an edge of the first connection area and an edge of the second connection area and along a side of the die. The method may further include curing the non-conductive material, thereby forming a first body of non-conductive material. The method may further include applying a conductive material, such as a conductive liquid, sinter paste or conductive particles and films (e.g., seed layers for plating), between the first connection area and the second connection area and along a surface of the first body of non-conductive material. The method may further include curing the conductive material, thereby forming a second body of conductive material.

In an embodiment, the method may include repeating the step of applying the non-conductive material before applying the conductive material to enlarge the first body of non-conductive material.

In an embodiment, the curing of the non-conductive material may include a box oven curing.

In an embodiment, the curing of the non-conductive material may include an ultra-violet (UV) curing.

In an embodiment, the curing of the conductive material may include a box oven curing.

In an embodiment, the curing of the conductive material may include sintering.

In an embodiment, the method may further include applying a seed layer on the surface of the first body of non-conductive material before applying the conductive material, e.g., before applying a conductive layer by electro or e-less plating.

In an embodiment, the method does not perform an etching or material removing of superfluous material from the first body of non-conductive material.

In an embodiment, the first connection area may be an area on the die.

In an embodiment, the die may be provided face down on the substrate.

In an embodiment, the first connection area may be an area on a bond pad provided on the die.

In an embodiment, the die may be provided face up on the substrate.

According to an aspect of the present disclosure, a semiconductor device package is provided, that may be manufactured using one or more of the above described methods.

In an embodiment, the semiconductor device package may be one of: a small outline diode (SOD); a clip bonded flat power package (CFP); a discrete package (Dpak); a dual discrete package (D²pak); a fan out panel level package (FOPLP); a loss-free package (LFPAK); and a copper clip package (CCPAK).

In an embodiment, the semiconductor device package may include a high-power transistor.

In an embodiment, the semiconductor device package may be a power metal-oxide-semiconductor field-effect transistor (power MOSFET).

In an embodiment, the semiconductor device package may include an IC.

### Brief description of the Drawings

Embodiments of the present disclosure will now be described, by way of example only, with reference to the accompanying schematic drawings in which corresponding reference symbol indicate corresponding parts, in which:
Figs. 1A-1C show a schematic side cross-section of a discrete semiconductor device package including a die face down on a substrate in various stages of bonding;
Figs. 2A-2C show a schematic side cross-section of a discrete semiconductor device package including a die face up on a substrate in various stages of bonding; and
Fig. 3 shows steps of a method of manufacturing a discrete semiconductor device package according to an example embodiment.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings,* the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure can be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

Clip bonding with high-lead solder is a known process of giving electrical connection between a power discrete and external leads of a semiconductor device. With the increasing concerns of environmental and European legislation, bonding solutions applying high-lead solder are preferably replaced with more environmental solutions. The present disclosure provides a drop-in solution to replace the copper clip and high-Pb solder pastes, most advantageously in power discrete applications.

The present disclosure enables a die to be bonded to a substrate bond pad by applying an insulating layer and an electrically conductive layer between the die and the substrate bond pad using curable liquid materials. Advantageously, the present disclosure can be applied to dies that are placed face down on a substrate and to dies that are placed face up on a substrate.

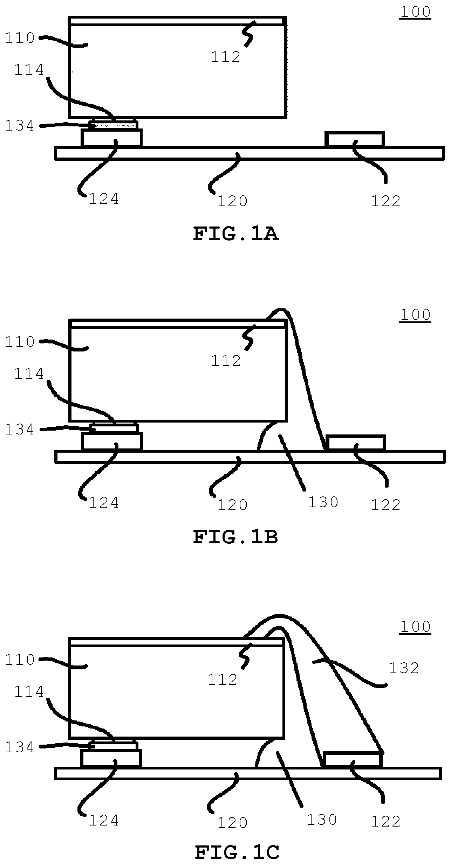

Fig. 1A shows a schematic side cross-section of a discrete semiconductor device package 100 including a die 110 that has been placed face down on a substrate 120. The present disclosure is not limited to discrete semiconductor device packages and may be applied to other packages, such as IC packages. Fig. 1B is the same as Fig. 1A, with the addition of non-conductive material 130 being applied between the die 110 and the edge of a substrate bond pad 122 and along a side of the die 110. Fig. 1C is the same as Fig. 1B, with the addition of a conductive material 132 being applied between the die and the substrate bond pad 122.

In the example of Fig. 1A, the die 110 is attached to the substrate 120 via bond pads 114 and 124 and a conductive layer 134. The present disclosure is not limited to this attachment through bond pads 114 and 124, which is only shown as an example.

On the bottom of the die 110, i.e., where the surface of the die 110 faces away from the substrate 120, a first connection area 112 may be present that is to be electrically connected to a second connection area 122 formed by the substrate bond pad provided on the substrate 120.

Fig. 1B shows a first body of non-conductive material 130 that has been created between an edge of the first connection area 112 and an edge of the substrate bond pad 122 and along a side of the die 110. The first body of non-conductive material 130 may be created by applying and curing a non-conductive liquid. Thus, the non-conductive material 130 may form an insulating layer. The non-conductive liquid may be printed, deposited or otherwise transfer from the top of the die, i.e., where the surface of the die 110 faces the substrate 120, a side of the die 110 and the and bottom of the die 110, to the top of the substrate 120 on the edge of the substrate bond pad 122.

Fig. 1C shows a second body of conductive material 132 that has been created between the first connection area 112 and the substrate bond pad 122 and along a surface of the first body of non-conductive material 130. The shape of the second body of conductive material 132 typically follows the outline of the first body of non-conductive material 130. The second body of conductive material 132 may be created by applying and a curing conductive material, e.g., a conductive liquid, a sinter paste and/or conductive particles and films (e.g., seed layers for plating). Thus, the conductive material 132 may form an electrically conductive layer.

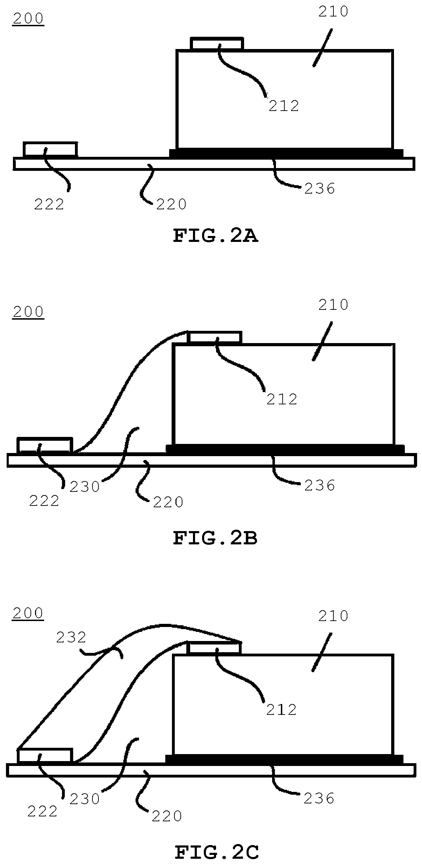

Fig. 2A shows a schematic side cross-section of a discrete semiconductor device package 200 including a die 210 that has been placed face up on a substrate 220. Fig. 2B is the same as Fig. 2A, with the addition of non-conductive material 230 being applied between the die 210 and the edge of a substrate bond pad 222 and along a side of the die 210. Fig. 2C is the same as Fig. 2B, with the addition of a conductive material 232 being applied between the die 210 and the substrate bond pad 222.

In the example of Fig. 2A, the die 210 is attached to the substrate 220 via a non-conductive layer 236. The present disclosure is not limited to this attachment through non-conductive layer 236, which is only shown as an example. Other examples of attaching the die 210 to the substrate 220 include using conductive material such as silver or copper sintering material.

On the top of the die 210, i.e., where the surface of the die 210 faces away from the substrate 220, a first connection area 212, e.g., in the form of a bond pad, may be present that is to be electrically connected to a second connection area 222 formed by the substrate bond pad provided on the substrate 220.

Fig. 2B shows a first body of non-conductive material 230 that has been created between an edge of the bond pad 212 and an edge of the substrate bond pad 222 and along a side of the die 210. The first body of non-conductive material 230 may be created by applying and curing a non-conductive liquid. Thus, the non-conductive material 230 may form an insulating layer. The non-conductive liquid may be printed, deposited or otherwise transfer from the bottom of the die, i.e., where the surface of the die 210 faces the substrate 220, a side of the die 210 and the and top of the die 210, to the top of the substrate 220 on the edge of the substrate bond pad 222.

Fig. 2C shows a second body of conductive material 232 that has been created between the bond pad 212 and the substrate bond pad 222 and along a surface of the first body of non-conductive material 230. The shape of the second body of conductive material 232 typically follows the outline of the first body of non-conductive material 230. The second body of conductive material 232 may be created by applying and curing a conductive material, e.g., a conductive liquid, a sinter paste and/or conductive particles and films (e.g., seed layers for plating). Thus, the conductive material 232 may form an electrically conductive layer.

Precision of the additive manufacture deposition tool used for applying the non-conductive liquid for the first body of non-conductive material 130, 230 may allow precise deposition of the liquid material as the tool traverses across on top of the substrate. Due to the accuracy of the machine, there may be no need for an etch or material removal step during the non-conductive deposition process.

To achieve a desirable results and protection of the die 110, 210, a single pass deposition of non-conductive material may not be sufficient. Therefore, multiple pass deposition may be applied to create the first body of non-conductive material 130, 230, depending on product requirements.

After applying the non-conductive liquid, the non-conductive material may be cured, e.g., by box oven curing or UV curing.

Conductive material deposition by an additive manufacture process for the creation of the second body of conducting material 132, 232 may be any of high thermally and electrically conductive materials such as conductive inks, conductive polymers, metal filled epoxies, sintering metallic power, liquid assisted sintering particles, solder paste, and etcetera.

After applying the conductive liquid, the conductive material may be cured, e.g., by sintering or box oven curing.

A seed layer (not shown) may be applied on the surface of the first body of non-conductive material 130, 230 before applying the conductive liquid for the second body of conductive material 132, 232.

Advantageously, the bonding method of the present disclosure, such as shown in Figs. 1A-1C and Figs. 2A-2C, may replace copper clip bonding and use of high-Pb solder, while providing high performance electrical bonding, even suitable for use in high-power semiconductor devices, such as power MOSFETs.

The present disclosure may be applied to a variety of semiconductor device packages. Non-limiting examples hereof are: SOD, CFP, Dpak, D²pak, FOPLP, LFPAK and CCPAK.

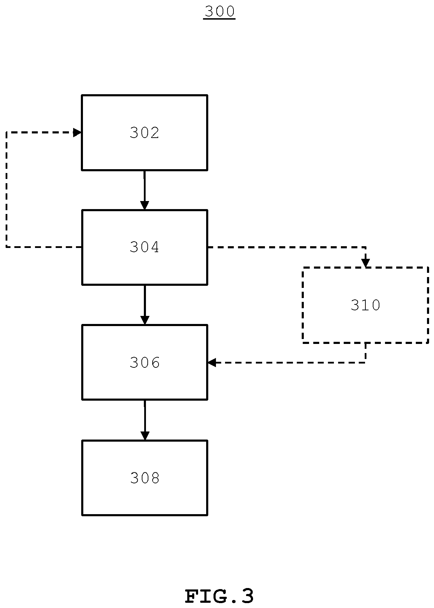

Fig. 3 shows an example process 300 of manufacturing a semiconductor device package, such as the discrete semiconductor device package 100 or 200.

In step 302, a non-conductive material, e.g., a non-conductive liquid, may be applied between the edge of the first connection area 112, 212 and an edge of the second connection area 122, 222 and along a side of the die 110, 210.

In step 304, the non-conductive liquid may be cured, thereby forming the first body of non-conductive material 130, 230.

Steps 302 and 304 may be repeated by applying a multi-pass deposition, which is depicted by the dashed arrow between steps 302 and 304.

In step 306, a conductive material, e.g., a conductive liquid, may be applied between the first connection area 112, 212 and the second connection area 122, 222 and along a surface of the first body of non-conductive material 130, 230.

In step 308, the conductive liquid may be cured, thereby forming the second body of conductive material 132, 232.

Step 310 indicates an optional step of applying a seed layer on the surface of the first body of non-conductive material 130, 230 before applying the conductive liquid for the second body of conductive material 132, 232.

## Claims

1. A method (300) of manufacturing a semiconductor device package (100, 200) comprising a die (110, 120), a substrate (120, 220), a first connection area (112, 212) and a second connection area (122, 222),
wherein the first connection area provides an electrical connection to the die,
wherein the second connection area provides an electrical connection to one of a substrate bond pad, a leadframe and a clip frame provided on the substrate,
and wherein the first connection area and the second connection area are facing in the same direction,
the method comprising:
applying (302) a non-conductive material between an edge of the first connection area and an edge of the second connection area and along a side of the die, and curing (304) the non-conductive material, thereby forming a first body of non-conductive material (130, 230);
applying (306) one or more of a conductive material between the first connection area and the second connection area and along a surface of the first body of non-conductive material, and curing (308) the conductive material, thereby forming a second body of conductive material (132, 232).

2. The method according to claim 1, wherein the method further comprises repeating the step of applying the non-conductive material before applying the conductive material to enlarge the first body of non-conductive material.

3. The method according to claim 1 or claim 2, wherein the curing of the non-conductive material comprises one of: a box oven curing; and an ultra-violet, UV, curing.

4. The method according to any one of the claims 1-3, wherein the curing of the conductive material comprises one of: a box oven curing; and sintering.

5. The method according to any one of the claims 1-4, further comprising applying (310) a seed layer on the surface of the first body of non-conductive material before applying the conductive material.

6. The method according to any one of the claims 1-5, wherein the method does not perform an etching or material removing of superfluous material from the first body of non-conductive material.

7. The method according to any one of the claims 1-6, wherein the first connection area is an area on the die.

8. The method according to claim 7, wherein the die is provided face down on the substrate.

9. The method according to any one of the claims 1-6, wherein the first connection area is an area on a bond pad provided on the die.

10. The method according to claim 9, wherein the die is provided face up on the substrate.

11. A semiconductor device package (100, 200) manufactured using the method according to any one of the claims 1-10.

12. The semiconductor device package according to claim 11, being one of: a small outline diode, SOD; a clip bonded flat power package, CFP; a discrete package, Dpak; a dual discrete package, D²pak; a fan out panel level package, FOPLP; a loss-free package, LFPAK; and a copper clip package, CCPAK.

13. The semiconductor device package according to claim 11, comprising a high-power transistor.

14. The semiconductor device package according to claim 13, comprising a power metal-oxide-semiconductor field-effect transistor, power MOSFET.

15. The semiconductor device package according to claim 13, comprising an integrated circuit, IC.
